# EUROPEAN PATENT SPECIFICATION

(11) **EP 3 248 713 B1**
(45) Date of publication and mention of the grant of the patent: **25.03.2020**
(21) Application number: 15881172.9
(22) Date of filing: 05.11.2015
(51) Int. Cl.: B22F 1/00, B22F 9/00, H01B 1/00, H01B 1/22, H01B 5/00, B22F 1/02, B22F 9/30, H01B 1/02, B22F 9/24, H05K 3/32

(54) **ELECTROCONDUCTIVE MICROPARTICLES**
ELEKTRISCH LEITENDE MIKROPARTIKEL
MICROPARTICULES ÉLECTROCONDUCTRICES

(30) Priority: 06.02.2015 JP 2015022333
(43) Date of publication of application: 29.11.2017
(73) Proprietor: Tokusen Kogyo Co., Ltd, Ono-City, Hyogo 675-1361 (JP)
(72) Inventor: LEE Woojin, Ono-City, Hyogo 675-1361 (JP); WAKASAKI Shun, Ono-City, Hyogo 675-1361 (JP); KANAMORI Takayuki, Ono-City, Hyogo 675-1361 (JP)
(74) Representative: Manitz Finsterwald Patent- und Rechtsanwaltspartnerschaft mbB
(86) International application number: PCT/JP2015/081105
(87) International publication number: WO 2016/125355

(56) References cited:
- WO-A1-2014/013785
- WO-A2-2007/065154
- JP-A- 2004 183 010
- JP-A- 2009 013 449
- JP-A- 2009 013 449
- JP-A- 2012 021 232
- JP-A- 2012 036 481
- JP-A- 2012 036 481
- JP-A- 2012 041 592
- JP-A- 2012 041 592
- JP-A- 2012 092 442
- JP-A- 2014 019 899
- JP-A- 2014 196 527
- US-A1- 2006 137 488
- US-A1- 2008 213 592

## Description

### TECHNICAL FIELD

The present invention relates to electrically conductive fine particles. Specifically, the present invention relates to fine particles that are flake-like and of which a main component is a metal.

### BACKGROUND ART

An electrically conductive paste is used for the production of printed circuit boards for electronic devices. The paste contains: fine particles of which a main component is a metal; a binder; and a liquid organic compound (solvent). By using the paste, a pattern of wiring that connects electronic components to each other is printed. After the printing, the paste is heated. By the heating, fine metal particles are sintered with fine metal particles adjacent thereto.

JP2007-254845 discloses particles of which a material is silver and that are flake-like. The particles are formed by processing spherical fine particles with a bead mill.

As a method for printing a pattern, an etching method, a squeegee method, and an inkjet method are adopted.

In the etching method, a paste is applied to a plate. A portion of the paste is covered by a mask. UV is applied to the exposed paste to partially cure the paste. The paste covered by the mask is not cured. Etching is performed on the plate to remove the uncured paste. As a result of this removal, a pattern is formed on the plate.

In the squeegee method, a groove is formed on a plate. A paste is applied to the plate. The paste is squeegeed with a doctor blade. By the squeegeeing, the paste present on the plate other than the groove is removed. The paste remains in the groove, and a pattern is formed.

In the inkjet method, a paste is jetted out from a nozzle. The paste adheres to a plate to obtain a pattern.

In any of the printing methods, a paste that allows for printing of narrow lines is desired. In other words, the paste needs to have good printing characteristics. Since the paste is heated, the paste also needs to have good thermal conductivity. Since the pattern is a path for electrons, the paste also needs to have good electrical conductivity.

Each of documents JP 2009-13449 A, JP 2012-036481 A, WO 2007/065154 A2 and WO 2014/013785 A1 discloses electrically conductive particles comprising fine particles that are flake-like and of which a main component is an electrically conductive metal, wherein the content of the metal in the particles is equal to or greater than 90% by weight, wherein the metal is a core, wherein the main component is silver. In JP 2009-13449 A and JP 2012-036481 A, the particles have a cumulative 50% by volume particle diameter D50 of 0.46 µm and 0.29 µm, respectively. In JP 2009-13449 A, D50 is measured by a laser diffraction/ scattering type particle size distribution measurement method.

### CITATION LIST

### PATENT LITERATURE

Patent Literature 1: JP2007-254845

### SUMMARY OF THE INVENTION

### PROBLEMS TO BE SOLVED BY THE INVENTION

The printing characteristics, the thermal conductivity, and the electrical conductivity of the powder disclosed in JP2007-254845 are not sufficient. An object of the present invention is to improve the printing characteristics, the thermal conductivity, and the electrical conductivity of particles including fine particles.

### SOLUTION TO THE PROBLEMS

Particles according to the present invention include fine particles. Each fine particle is flake-like, and a main component thereof is an electrically conductive metal. The content of the metal in the particles is equal to or greater than 90% by weight. The metal is a core. The core is monocrystalline as a whole. The main component is silver. A cumulative 50% by volume particle diameter D50 of the particles is equal to or greater than 0.10 µm but equal to or less than 0.50 µm, a cumulative 95% by volume particle diameter D95 of the particles is equal to or less than 1.00 µm, and a maximum particle diameter Dmax of the particles is equal to or less than 3.00 µm. The particle diameters D50, D59, and Dmax are measured by a laser diffraction/scattering type particle size distribution measurement method.

Preferably, a cumulative 10% by volume particle diameter D10 of the particles measured by the laser diffraction/scattering type particle size distribution measurement method is equal to or greater than 0.05 µm.

Preferably, a BET specific surface area of the particles is equal to or greater than 2.0 m²/g.
Preferably, a tap density TD of the particles is equal to or greater than 2.0 g/cm³.

Preferably, an average Tave of thicknesses of the fine particles is equal to or less than 0.05 µm.

An electrically conductive paste according to the present invention includes:
(1) particles according to any of claims 1 to 6; and
(2) a solvent.

### ADVANTAGEOUS EFFECTS OF THE INVENTION

The particles according to the present invention include fine particles. The fine particles are extremely small. In a paste, the fine particles disperse sufficiently. The paste containing the fine particles has good printing characteristics.

Since the fine particles are flake-like, the fine particles overlap each other with a large contact surface area in the paste after printing. Therefore, the paste exhibits high thermal conductivity during heating. The paste can be successfully sintered by heating for a short time. The paste can be successfully sintered by heating at low temperature.

In a pattern after sintering, the fine particles overlap each other with a large contact surface area. Therefore, the pattern easily conducts electricity. The fine particles also have good electrical conductivity.

### BRIEF DESCRIPTION OF THE DRAWINGS

[FIG. 1] FIG. 1 is a perspective view showing a fine particle included in particles according to an embodiment of the present invention.
[FIG. 2] FIG. 2 is a microscope image showing the particles including the fine particle in FIG. 1.
[FIG. 3] FIG. 3 is a graph showing a cumulative curve of the particles in FIG. 2.

### DESCRIPTION OF EMBODIMENTS

The following will describe in detail the present invention on the basis of preferred embodiments with appropriate reference to the accompanying drawings.

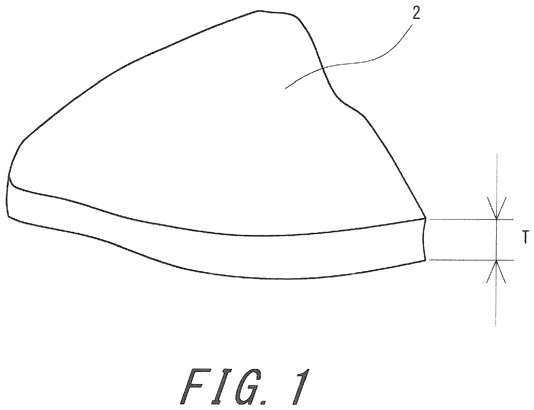

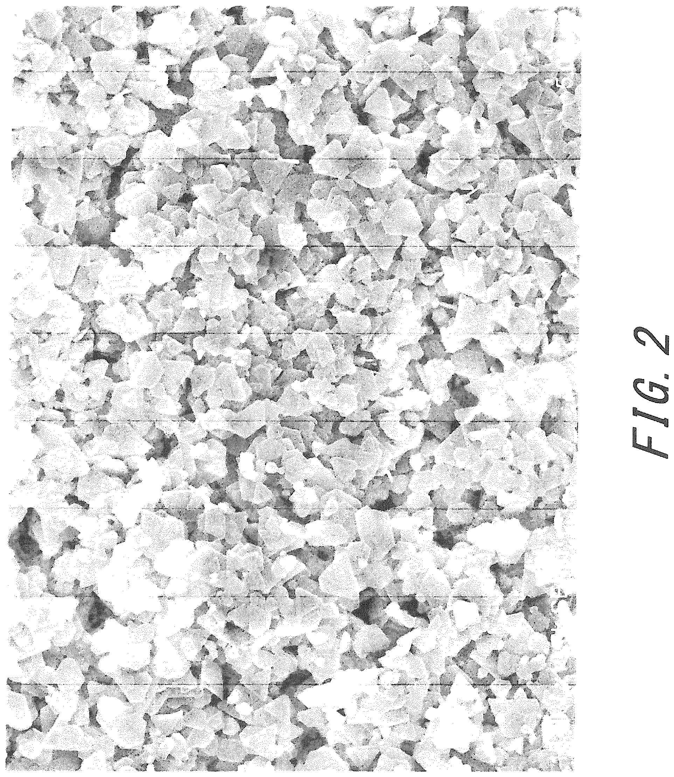

FIG. 1 shows a fine particle 2. The fine particle 2 is flake-like. The fine particle 2 is so-called nano-flake. Aggregation of a large number of fine particles 2 is particles. FIG. 2 shows a microscope image of the particles.

The main component of the fine particles 2 is an electrically conductive metal, namely silver.

Each fine particle 2 may contain a substance other than the metal. Examples of the substance other than the metal include organic matter. The organic matter can adhere to the surface of the metal.

The content of the metal in the particles is equal to or greater than 90% by weight and preferably equal to or greater than 95% by weight.

A typical application of the fine particles 2 is an electrically conductive paste. An electrically conductive paste is obtained by mixing a large number of the fine particles 2 with a solvent. The paste can contain a binder, a dispersant, and the like. By using the paste, a pattern can be printed on a plate. Examples of a typical printing method include the above-described etching method, the above-described squeegee method, and the above-described inkjet method.

Since the fine particles 2 are flake-like, the fine particles 2 overlap each other with a large contact surface area in the paste after printing. Therefore, the paste exhibits high thermal conductivity during heating. The paste can be successfully sintered by heating for a short time. During the heating for a short time, electronic components and a substrate are unlikely to be damaged. The paste can be successfully sintered by heating at low temperature. During the heating at low temperature, electronic components and a substrate are unlikely to be damaged.

Since the fine particles 2 are flake-like, the fine particles 2 overlap each other with a large contact surface area in a pattern after sintering. Therefore, the pattern easily conducts electricity. The particles have good electrical conductivity.

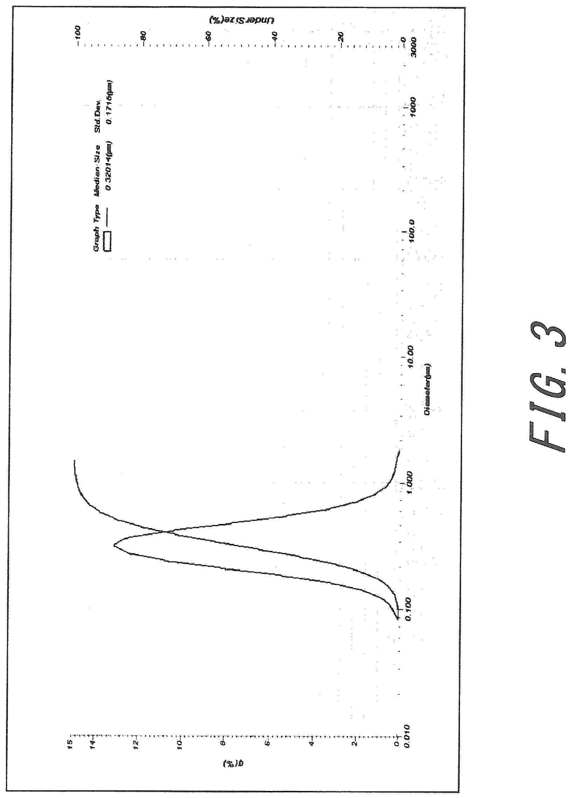

In the present invention, a cumulative curve of the particles is obtained by a laser diffraction/scattering type particle size distribution measurement method. FIG. 3 shows the cumulative curve. In FIG. 3, the horizontal axis indicates a particle diameter (µm), and the vertical axis indicates a ratio (%). The cumulative curve is obtained by using a laser diffraction particle size distribution meter (LA-950V2, manufactured by HORIBA, Ltd.). On the basis of the cumulative curve, a cumulative 10% by volume particle diameter D10, a cumulative 50% by volume particle diameter D50, a cumulative 95% by volume particle diameter D95, a maximum particle diameter Dmax, and a particle diameter standard deviation σD are measured. The particle diameter at a point of 10% by volume on the cumulative curve is D10, the particle diameter at a point of 50% by volume on the cumulative curve is D50, and the particle diameter at a point of 95% by volume on the cumulative curve is D95. The particle diameter of the largest fine particle 2 is Dmax. The conditions for the measurement are as follows.
Mode: scattering, wet (water)
Laser light: 80-90%
LED light: 70-90%

In the particles, the particle diameter D50 is equal to or greater than 0.10 µm but equal to or less than 0.50 µm, the particle diameter D95 is equal to or less than 1.00 µm, and the particle diameter Dmax is equal to or less than 3.00 µm. In other words, the particles include many extremely small particles and do not include large particles. A paste obtained from the particles is suitable for printing a pattern having a small wiring width (i.e., a fine pattern).

The particle size distribution curve of the particles having the particle diameters D50 and D90 within the above range is sharp. In other words, in the particles, variation in the particle diameters is small. Therefore, the particles do not include many excessively small particles. The particles have a good filling factor in squeegeeing. Furthermore, the particles are easily wiped off. In other words, the particles have good handleability.

In light of printing characteristics, the particle diameter D50 is more preferably equal to or less than 0.46 µm and particularly preferably equal to or less than 0.40 µm. In light of handleability, the particle diameter D50 is more preferably equal to or greater than 0.20 µm and particularly preferably equal to or greater than 0.30 µm.

In light of printing characteristics, the particle diameter D95 is more preferably equal to or less than 0.90 µm and particularly preferably equal to or less than 0.80 µm. The particle diameter D95 is preferably equal to or greater than 0.50 µm.

In light of printing characteristics, the particle diameter Dmax is more preferably equal to or less than 2.80 µm and particularly preferably equal to or less than 2.60 µm.

The particle diameter D10 is preferably equal to or greater than 0.05 µm. The particles having a particle diameter D10 of equal to or greater than 0.05 µm have a good filling factor in squeegeeing. Furthermore, the particles are easily wiped off. In other words, the particles have good handleability. In light of handleability, the particle diameter D10 is more preferably equal to or greater than 0.10 µm and particularly preferably equal to or greater than 0.15 µm. The particle diameter D10 is preferably equal to or less than 0.30 µm.

The particle diameter standard deviation σD is preferably equal to or less than 1.00 µm. The particles having a standard deviation σD of equal to or less than 1.00 µm have good printing characteristics, good electrical conductivity, and good handleability. From this standpoint, the standard deviation σD is more preferably equal to or less than 0.50 µm and particularly preferably equal to or less than 0.25 µm.

An average thickness Tave of the fine particles 2 is preferably equal to or less than 0.05 µm. In a paste containing the fine particles 2 having an average thickness Tave of equal to or less than 0.05 µm, the fine particles 2 overlap each other with a large contact surface area. Therefore, the paste exhibits high thermal conductivity during heating. The paste can be successfully sintered by heating for a short time. During the heating for a short time, electronic components and a substrate are unlikely to be damaged. The paste can be successfully sintered by heating at low temperature. During the heating at low temperature, electronic components and a substrate are unlikely to be damaged. In a pattern obtained from the paste by sintering, the fine particles 2 overlap each other with a large contact surface area. Therefore, the pattern easily conducts electricity. In light of thermal conductivity and electrical conductivity, the average thickness Tave is particularly preferably equal to or less than 0.04 µm. From the standpoint that the particles can be easily produced, the average thickness Tave is more preferably equal to or greater than 0.01 µm and particularly preferably equal to or greater than 0.02 µm. The average thickness Tave is calculated by averaging thicknesses T (see FIG. 1) of 100 fine particles 2 that are extracted randomly. Each thickness T is visually measured on the basis of an SEM photograph.

The particles preferably have an aspect ratio (D50/Tave) of equal to or greater than 5 but equal to or less than 30. The particles having an aspect ratio (D50/Tave) of equal to or greater than 5 have good electrical conductivity and good thermal conductivity. From this standpoint, the aspect ratio (D50/Tave) is preferably equal to or greater than 8 and particularly preferably equal to or greater than 10. The particles having an aspect ratio (D50/Tave) of equal to or less than 30 can be easily produced. From this standpoint, the aspect ratio (D50/Tave) is more preferably equal to or less than 25 and particularly preferably equal to or less than 20.

The particles preferably have a BET specific surface area of equal to or greater than 2.0 m²/g. In a paste containing the particles having a BET specific surface area of equal to or greater than 2.0 m²/g, the fine particles 2 overlap each other with a large contact surface area. Therefore, the paste exhibits high thermal conductivity during heating. The paste can be successfully sintered by heating for a short time. During the heating for a short time, electronic components and a substrate are unlikely to be damaged. The paste can be successfully sintered by heating at low temperature. During the heating at low temperature, electronic components and a substrate are unlikely to be damaged. In a pattern obtained from the paste by sintering, the fine particles 2 overlap each other with a large contact surface area. Therefore, the pattern easily conducts electricity. In light of thermal conductivity and electrical conductivity, the BET specific surface area is more preferably equal to or greater than 2.5 m²/g and particularly preferably equal to or greater than 3.0 m²/g. From the standpoint that the particles can be easily produced, the BET specific surface area is preferably equal to or less than 4.0 m²/g. The BET specific surface area is measured in accordance with the standards of "JIS Z 8830: 2013".

The particles preferably have a tap density TD of equal to or greater than 2.0 g/cm³. By the particles having a tap density TD of equal to or greater than 2.0 g/cm³, a pattern having good electrical conductivity is obtained. From this standpoint, the tap density TD is more preferably equal to or greater than 2.5 g/cm³ and particularly preferably equal to or greater than 3.0 g/cm³. The tap density TD is preferably equal to or less than 4.0 g/cm³. The tap density TD is measured in accordance with the standards of "JIS Z 2512: 2012".

As described above, each fine particle 2 can include a metal portion and organic matter adhering to the surface of the metal portion. The metal portion is a so-called core. The core is monocrystalline as a whole. Each fine particle 2 having the core has a smooth surface. The fine particles 2 have good printing characteristics, good electrical conductivity, and good thermal conductivity.

The following will describe an example of a method for producing the fine particles 2 of which a main component is silver. In the production method, a silver compound is dispersed in a carrier, which is a liquid, by a dispersant. A typical silver compound is silver oxalate. Silver oxalate can be obtained through a reaction of a solution of the silver compound, which is a material, and an oxalate compound. Impurities are removed from a precipitate obtained from the reaction, to obtain powder of silver oxalate.

From the standpoint of having less adverse effect on the environment, a hydrophilic liquid is used as the carrier. Specific examples of a preferable carrier include water and alcohols. The boiling points of water and alcohols are low. With dispersion liquids in which water and alcohols are used, pressure is easily increased. Preferable alcohols are ethyl alcohol, methyl alcohol, and propyl alcohol. Two or more liquids may be used in combination for the carrier.

Silver oxalate does not substantially dissolve in the carrier. Silver oxalate is dispersed in the carrier. The dispersion can be enhanced through ultrasonic wave treatment. The dispersion can be enhanced also with a dispersant. The PH of this dispersion liquid is adjusted. The PH adjustment can be made by addition of an acid.

The dispersion liquid, in a state of being pressurized by compressed air, is heated while being stirred. The heating causes a reaction represented by the following formula. In other words, silver oxalate is decomposed by heat.

Ag₂C₂O₄ = 2Ag + 2CO₂

In the dispersion liquid, silver is deposited as particles. An organic compound derived from silver oxalate, the carrier, or the dispersant adheres to the surfaces of the silver particles. The organic compound is chemically bonded to the silver particles. In other words, the fine particles 2 contain silver and the organic compound. The main component of the fine particles 2 is silver. With respect to the weight of the fine particles 2, the weight of silver accounts for preferably 99.0% or higher, and particularly preferably 99.5% or higher. The fine particles 2 do not need to include the organic compound.

Means for obtaining particles having a cumulative 50% by volume particle diameter D50 of equal to or greater than 0.10 µm but equal to or less than 0.50 µm, a cumulative 95% by volume particle diameter D95 of equal to or less than 1.00 µm, and a maximum particle diameter Dmax of equal to or less than 3.00 µm, includes:
(1) setting the concentration of silver oxalate in the dispersion liquid within a predetermined range,
(2) using a specific dispersant,
(3) setting the pressure upon heating within a predetermined range,
(4) setting the stirring speed within a predetermined range,
(5) adjusting the PH of the dispersion liquid to an appropriate PH, etc.

The concentration of silver oxalate in the dispersion liquid is preferably equal to or greater than 0.1 M but equal to or less than 1.0 M. From the dispersion liquid in which the concentration is within the above range, particles having small particle diameters D50, D95, and Dmax can be obtained. From this standpoint, the concentration is particularly preferably equal to or greater than 0.2 M but equal to or less than 0.7 M.

A preferable dispersant is a glycol dispersant. From a dispersion liquid containing the glycol dispersant, particles having small particle diameters D50, D95, and Dmax can be obtained. From the dispersion liquid, particles having a high aspect ratio (D50/Tave) can be obtained. Furthermore, the particles produced from the dispersion liquid disperse sufficiently in the solvent. A particularly preferable dispersant is polyethylene glycol.

The pressure of an environment during the decomposition reaction of silver oxalate is preferably higher than atmospheric pressure. As a result of the decomposition reaction in the environment, particles having small particle diameters D50, D95, and Dmax can be obtained. From this standpoint, the pressure is preferably equal to or greater than 2 kgf/cm². The pressure is preferably equal to or less than 10 kgf/cm².

The stirring speed when conducting the decomposition reaction of silver oxalate is preferably equal to or greater than 200 rpm. With a level of stirring at a speed of equal to or greater than 200 rpm, particles having small particle diameters D50, D95, and Dmax can be obtained. Furthermore, with a level of stirring at a speed of equal to or greater than 200 rpm, particles having a high aspect ratio (D50/Tave) can be obtained. From these standpoints, the stirring speed is particularly preferably 300 rpm. The stirring speed is preferably equal to or less than 1000 rpm.

A PH adjuster can be added to the dispersion liquid. The PH of the dispersion liquid is preferably equal to or greater than 2.0 but equal to or less than 5.0. From the dispersion liquid having a PH within the above range, particles having small particle diameters D50, D95, and Dmax can be obtained. From this standpoint, the PH is particularly preferably equal to or greater than 2.5 but equal to or less than 4.0. Examples of the PH adjuster include formic acid, acetic acid, propionic acid, trifluoroacetic acid, hydrofluoric acid, nitric acid, hydrochloric acid, sulfuric acid, and phosphoric acid. For the reason that elements (F, N, P, Cl, etc.) that are causes for impurities are not contained, formic acid, acetic acid, and propionic acid are preferable.

The temperature of the dispersion liquid when conducting the decomposition reaction of silver oxalate is preferably equal to or higher than 100°C. In the dispersion liquid of which the temperature is equal to or higher than 100°C, the reaction is completed in a short time. From this standpoint, the temperature is particularly preferably equal to or higher than 120°C. In light of energy cost, the temperature is preferably equal to or lower than 150°C.

As described above, an electrically conductive paste is obtained by mixing a large number of the fine particles 2, a solvent, etc. Examples of the solvent include: alcohols such as aliphatic alcohols, alicyclic alcohols, aromatic-aliphatic alcohols, and polyhydric alcohols; glycol ethers such as (poly)alkylene glycol monoalkyl ethers and (poly)alkylene glycol monoaryl ethers; glycol esters such as (poly)alkylene glycol acetates; glycol ether esters such as (poly)alkylene glycol monoalkyl ether acetates; hydrocarbons such as aliphatic hydrocarbons and aromatic hydrocarbons; esters; ethers such as tetrahydrofuran and diethyl ether; and amides such as dimethylformamide (DMF), dimethylacetamide (DMAC), and N-methyl-2-pyrrolidone (NMP). Two or more solvents may be used in combination.

### EXAMPLES

The following will show the effects of the present invention by means of examples, but the present invention should not be construed in a limited manner based on the description of these examples.

### [Example 1]

Fifty grams of silver nitrate was dissolved in 1 L of distilled water to obtain a first solution. Meanwhile, 22.2 g of oxalic acid was dissolved in 1 L of distilled water to obtain a second solution. The first solution was mixed with the second solution to obtain a mixture liquid containing silver oxalate. Impurities were removed from this mixture liquid. Three grams of polyethylene glycol (dispersant) was added to 1 L of the mixture liquid, and the mixture liquid was stirred for 30 minutes while ultrasonic waves were applied thereto. With this, silver oxalate was dispersed. An appropriate amount of acetic acid was added to the dispersion liquid to adjust the PH of the dispersion liquid to 3. The dispersion liquid was placed in an autoclave. The dispersion liquid was pressurized at a pressure of 0.5 MPa. The dispersion liquid was heated to 130°C while being stirred at a speed of 300 rpm. The stirring was conducted for 30 minutes at this temperature to obtain a liquid containing fine particles of which a main component is silver.

### [Example 2]

A liquid containing fine particles was obtained in the same manner as Example 1, except formic acid was added to the dispersion liquid instead of acetic acid to adjust the PH to 4, the temperature of the dispersion liquid was set to 150°C, and the stirring speed was set to 350 rpm.

### [Example 3]

A liquid containing fine particles was obtained in the same manner as Example 1, except propionic acid was added to the dispersion liquid instead of acetic acid to adjust the PH to 5, pressure was not applied before the reaction, and the temperature during the reaction was set to 150°C.

### [Comparative Example 1]

A liquid containing fine particles was obtained in the same manner as Example 1, except the PH was set to 7 by not adding acetic acid, pressure was not applied before the reaction, the temperature during the reaction was set to 120°C, and the stirring speed during the reaction was set to 150 rpm.

### [Comparative Example 2]

Spherical fine particles composed of silver were processed into a flake-like shape using a ball mill.

### [Evaluation of Printing Characteristics]

A large number of fine particles, a binder, and a dispersant were mixed to obtain an electrically conductive paste. Wiring having line widths of 3 µm, 10 µm, and 60 µm was printed by using the electrically conductive paste. The printed states were observed with a microscope. The case where favorable wiring was printed was evaluated as "Good", and the case where favorable wiring was not printed was evaluated as "Bad". The results are shown in Table 1 below.

### [Evaluation of Electrical Conductivity]

Wiring having a line width of 60 µm was heated under the following condition. The electrical resistivity of the wiring after the heating was measured. The results are shown in Table 1 below. The case where the electrical resistivity was too high to be measured is represented as Over Range in Table 1.

### [Table 1]

**Table 1 Results of Evaluation**

| | Ex. 1 | Ex. 2 | Ex. 3 | Comp. Ex. 1 | Comp. Ex. 2 |
|---|---|---|---|---|---|
| D10 (µm) | 0.19 | 0.24 | 0.29 | 1.27 | 6.93 |
| D50 (µm) | 0.32 | 0.40 | 0.46 | 2.32 | 14.06 |
| D95 (µm) | 0.66 | 0.81 | 0.92 | 4.87 | 32.30 |
| Dmax (µm) | 1.73 | 2.27 | 2.60 | 8.81 | 48.26 |
| σD (µm) | 0.17 | 0.21 | 0.24 | 1.19 | 7.32 |
| Tave (µm) | 0.02 | 0.03 | 0.04 | 0.05 | 0.09 |
| D50/Tave | 16.0 | 13.3 | 11.6 | 46.3 | 156.2 |
| BET specific surface area (m²/g) | 3.1 | 3.0 | 2.7 | 2.4 | 1.5 |
| TD (g/cm³) | 3.4 | 3.6 | 2.7 | 2.2 | 1.9 |

| Printing characteristics | | | | | |
|---|---|---|---|---|---|
| Width: 3 µm | Good | Good | Good | Bad | Bad |
| Width: 10 µm | Good | Good | Good | Good | Bad |
| Width: 60 µm | Good | Good | Good | Good | Good |

| Electrical resistivity (µΩ · cm) | | | | | |
|---|---|---|---|---|---|
| 130°C × 30 min | 254.0 | 309.1 | 273.4 | Over Range | Over Range |
| 150°C × 30 min | 55.9 | 60.5 | 56.5 | 150.9 | Over Range |
| 180°C × 30 min | 16.1 | 19.3 | 18.9 | 40.2 | 219.7 |
| 200°C × 30 min | 4.9 | 5.5 | 5.2 | 5.4 | 15.6 |

As shown in Table 1, the wiring obtained from the fine particles of each example has good printing characteristics and good electrical conductivity. From the results of evaluation, advantages of the present invention are clear.

### INDUSTRIAL APPLICABILITY

The particles according to the present invention can be used for a paste for printed circuits, a paste for electromagnetic wave shielding films, a paste for electrically conductive adhesives, and a paste for die bonding, and the like.

### DESCRIPTION OF THE REFERENCE CHARACTERS

- 2: fine particle

## Claims

1. Electrically conductive particles comprising fine particles that are flake-like and of which a main component is an electrically conductive metal, wherein the content of the metal in the particles is equal to or greater than 90% by weight, wherein the metal is a core, wherein the core is monocrystalline as a whole, wherein the main component is silver, wherein
the particles have a cumulative 50% by volume particle diameter D50, measured by a laser diffraction/scattering type particle size distribution measurement method, of equal to or greater than 0.10 µm but equal to or less than 0.50 µm, a cumulative 95% by volume particle diameter D95, measured by the laser diffraction/scattering type particle size distribution measurement method, of equal to or less than 1.00 µm, and a maximum particle diameter Dmax, measured by the laser diffraction/scattering type particle size distribution measurement method, of equal to or less than 3.00 µm.

2. The particles according to claim 1, wherein each fine particle includes organic matter adhering to the surface of the core.

3. The particles according to claim 1 or 2, wherein the particles have a cumulative 10% by volume particle diameter D10, measured by the laser diffraction/scattering type particle size distribution measurement method, of equal to or greater than 0.05 µm.

4. The particles according to any one of claims 1 to 3, wherein the particles have a BET specific surface area of equal to or greater than 2.0 m²/g.

5. The particles according to any one of claims 1 to 4, wherein the particles have a tap density TD of equal to or greater than 2.0 g/cm³.

6. The particles according to any one of claims 1 to 5, wherein an average Tave of thicknesses of the fine particles is equal to or less than 0.05 µm.

7. An electrically conductive paste comprising:
(1) particles according to any of claims 1 to 6; and
(2) a solvent.

## Patentansprüche

1. Elektrisch leitfähige Partikel, welche feine Partikel umfassen, die flockenartig sind und wovon ein Hauptbestandteil ein elektrisch leitfähiges Metall ist, wobei der Gehalt des Metalls in den Partikeln gleich oder größer als 90 Gewichtsprozent ist, wobei das Metall ein Kern ist, wobei der Kern als Ganzes monokristallin ist, wobei der Hauptbestandteil Silber ist, wobei
die Partikel einen Partikeldurchmesser D50 für 50% kumulatives Volumen, gemessen durch ein Partikelgrößenverteilungs-Messverfahren des Laser-Beugungs/Streuungs-Typs, von gleich oder größer als 0,10 µm, aber gleich oder kleiner als 0,50 µm, einen Partikeldurchmesser D95 für 95% kumulatives Volumen, gemessen durch das Partikelgrößenverteilungs-Messverfahren des Laser-Beugungs/Streuungs-Typs, von gleich oder kleiner als 1,00 µm und einen maximalen Partikeldurchmesser Dmax, gemessen durch das Partikelgrößenverteilungs-Messverfahren des Laser-Beugungs/Streuungs-Typs, von gleich oder kleiner als 3,00 µm aufweist.

2. Partikel nach Anspruch 1, wobei jedes feine Partikel an der Oberfläche des Kerns anhaftende organische Materie umfasst.

3. Partikel nach Anspruch 1 oder 2, wobei die Partikel einen Partikeldurchmesser D10 für 10% kumulatives Volumen, gemessen durch das Partikelgrößenverteilungs-Messverfahren des Laser-Beugungs/Streuungs-Typs, von gleich oder größer als 0,05 µm aufweisen.

4. Partikel nach einem der Ansprüche 1 bis 3, wobei die Partikel eine spezifische BET-Oberfläche von gleich oder größer als 2,0 m²/g aufweisen.

5. Partikel nach einem der Ansprüche 1 bis 4, wobei die Partikel eine Klopfdichte TD von gleich oder größer als 2,0 g/cm³ aufweisen.

6. Partikel nach einem der Ansprüche 1 bis 5, wobei ein Durchschnittswert Tave der Dicken der feinen Partikel gleich oder kleiner als 0,05 µm ist.

7. Elektrisch leitfähige Paste, welche umfasst:
(1) Partikel nach einem der Ansprüche 1 bis 6; und
(2) ein Lösungsmittel.

## Revendications

1. Particules électriquement conductrices comprenant de fines particules qui sont en forme de flocons et dont un composant principal est un métal électriquement conducteur, dans lesquelles la teneur en métal dans les particules est égale ou supérieure à 90 % en poids, dans lesquelles le métal est un noyau, dans lesquelles le noyau est monocristallin dans son ensemble, dans lesquelles le composant principal est l'argent, lesquelles particules ont un diamètre de particule cumulé en volume de 50 % D50, mesuré par une méthode de mesure de la distribution de la taille des particules de type diffraction/diffusion laser, égal ou supérieur à 0,10 µm mais inférieur ou égal à 0,50 µm, un diamètre de particule cumulé en volume de 95 % D95, mesuré par la méthode de mesure de la distribution de la taille des particules par diffraction/diffusion laser, inférieur ou égal à 1,00 µm, et un diamètre maximal de particules Dmax, mesuré par la méthode de mesure de la distribution de la taille des particules par diffraction/diffusion laser, inférieur ou égal à 3,00 µm.

2. Particules selon la revendication 1, dans lesquelles chaque particule fine comprend de la matière organique adhérant à la surface du noyau.

3. Particules selon la revendication 1 ou 2, lesquelles particules ont un diamètre de particule cumulé en volume de 10 % D10, mesuré par la méthode de mesure de la distribution de la taille des particules par diffraction/diffusion laser, égal ou supérieur à 0,05 µm.

4. Particules selon l'une quelconque des revendications 1 à 3, lesquelles particules ont une surface spécifique BET égale ou supérieure à 2,0 m²/g.

5. Particules selon l'une quelconque des revendications 1 à 4, lesquelles particules ont une densité après tassement TD égale ou supérieure à 2,0 g/cm³.

6. Particules selon l'une quelconque des revendications 1 à 5, dans lesquelles une valeur moyenne Tave des épaisseurs des fines particules est égale ou inférieure à 0,05 µm.

7. Pâte conductrice de l'électricité comprenant :
(1) des particules selon l'une quelconque des revendications 1 à 6 ; et
(2) un solvant.
